# EUROPEAN PATENT SPECIFICATION

(11) **EP 0 840 366 B1**
(45) Date of publication and mention of the grant of the patent: **01.08.2001**
(21) Application number: 97108763.0
(22) Date of filing: 02.06.1997
(51) Int. Cl.: H01L 21/316

(54) **Method of forming a phosphorus doped silica glass film**
Herstellungsmethode eines Phosphor-gedopten Silica-Glasfilms
Méthode de fabrication d'une couche de silica dopée par phosphore

(30) Priority: 30.10.1996 JP 28878796
(43) Date of publication of application: 06.05.1998
(73) Proprietor: CANON SALES CO., INC., Minato-ku, Tokyo 108 (JP); SEMICONDUCTOR PROCESS LABORATORY CO., LTD., Minato-ku, Tokyo 108 (JP)
(72) Inventor: Tokumasu, Noboru, 13-29, Konan 2-chome, Minato-ku, Tokyo (JP); Maeda, Kazuo, 13-29, Konan 2-chome, Minato-ku, Tokyo (JP)
(74) Representative: Marx, Lothar, Dr.

(56) References cited:
- EP-A- 0 339 385
- EP-A- 0 562 625
- EP-A- 0 624 660

## Description

### BACKGROUND OF THE INVENTION

### 1. Field of the Invention

The present invention relates to a film forming method and a semiconductor device manufacturing method and, more particularly, a film forming method for use in forming a planarized interlayer insulating film for covering interconnection layers, etc. of a semiconductor integrated circuit device and a semiconductor device manufacturing method.

### 2. Description of the Prior Art

In recent years, there frequently occur cases in which multilayered interconnection layers extending over several layers or more have been formed with the progress in high integration density in the field of the semiconductor integrated circuit device. In such cases, it is urgently requested to develop a film forming method by which a planarized interlayer insulating film can be formed at a lower temperature of 500 °C or lower because aluminum material has often been used as the interconnection layers in particular.

In the prior art, there have been two typical methods as a method for planarizing the insulating film. One is that, as shown in FIGS.1A and 1B, first a film is formed in terms of thermal CVD method, plasma enhanced CVD method, or the like and then the film is planarized in terms of heating and flow, and the other is that, like the etching back method shown in FIGS.2A to 2C or the CMP (chemical mechanical polishing) method shown in FIGS.3A and 3B, unevenness of the surface of the insulating film is removed by etching or polishing to thus be planarized.

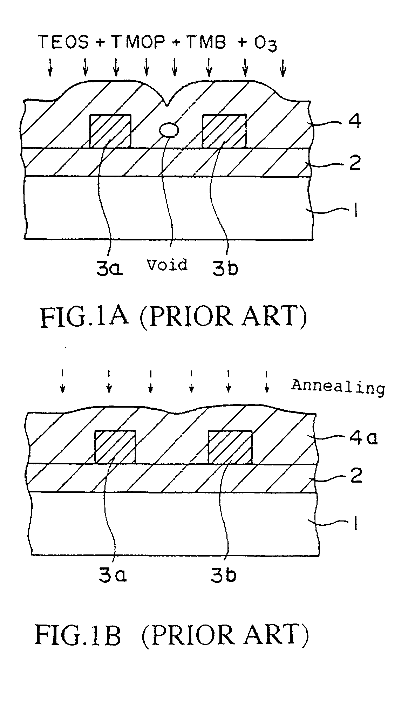

In the case of the former, as shown in FIG.1A, a BPSG (borophosphosilicate glass) film 4 is formed in terms of thermal CVD method using selectively the following reaction gases,
(1) SiH₄+PH₃+B₂H₆+O₂ (PH₃: phosphine), and
(2) TEOS+TMOP+TMB or TEB+O₂ or O₃
   (TEOS: tetraethylorthosilicate TMOP: trimethylphosphate (PO(OCH₃)₃)).(Si(OC₂H₅)₄),
Otherwise, as shown in FIG.1A, the BPSG film 4 is formed in terms of plasma enhanced CVD method using selectively the following reaction gases,
(1) SiH₄+PH₃+B₂H₆+O₂, and
(2) TEOS+TMOP+TMB or TEB+O₂.
See literatures, for instance, Williams, D.S. and Dein, E.A.: J. Electrochem. Soc., 134,3,: 657, 1987, Levin, R.M. and Evans-Lutterodt, K.: J. Vac. Sci. Technol., B1, 1:54, 1983, and Sato, J. and Maeda, K.: Extended Abstract of Electrochem. Soc. Spring Meeting: 31,1971.

After this, as shown in FIG.1B, the BPSG film 4 thus formed is heated at about 850 °C to be fluidized, thereby achieving planarization of the surface. In the case of the PSG film, at first the PSG film is formed in terms of thermal CVD method, plasma enhanced CVD method, etc. while using a reaction gas in which boron containing gas (B₂H₆, TMB, or TEB) is extracted from the above described reaction gas, and then the PSG film thus obtained is heated at a temperature of 1000 °C or lower to be fluidized, so that the surface of the PSG film is planarized.

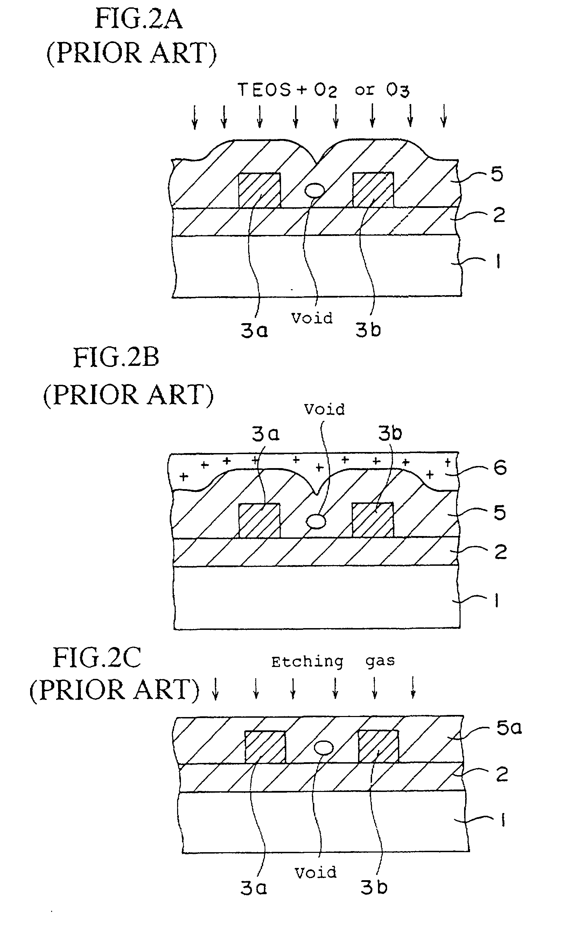

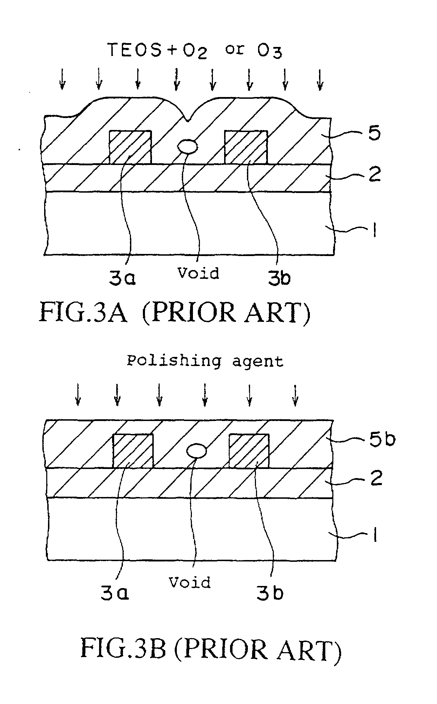

In the case of the latter, as shown in FIGS.2A and 3A, a NSG film 5 is formed at first in terms of thermal CVD method, plasma enhanced CVD method, or the like using selectively the following reaction gases,
(1) SiH₄+O₂ (thermal CVD method or plasma enhanced CVD method),
(2) TEOS+O₂ or O₃ (thermal CVD method), and
(3) TEOS+O₂ (plasma enhanced CVD method).

According to the etching back method, as shown in FIG.2B, a resist film 6 is coated on the NSG film 5 so that an entire surface is planarized, and then, as shown in FIG.2C, the planarized NSG film 5a is formed via etching process. In the meanwhile, according to the CMP method, as shown in FIG.3B, the above NSG film 5 is formed and then a surface of the NSG film 5b is planarized by polishing process.

In FIGS.1 to 3, a reference 1 denotes a semiconductor substrate; 2, a ground insulating film; and 3a, 3b, interconnection layers formed on the ground insulating film 2.

The planarization method in terms of the etching back method and the CMP method described above is effective in such case that low temperature treatment is needed since no heating process is required, unlike the planarization method using fluidization by heating (reflow). However, as shown in FIGS.2A, 2B and FIGS.3A, 3B, if voids are formed in the concave portions between the interconnection layers 3a, 3b, etc. immediately after the insulating film 5 is formed, such voids still remain as they are after planarization. At present, high density plasma CVD (HDP-CVD) method, plasma enhanced CVD method, atmospheric pressure thermal CVD method, SOG (spin-on-glass) coating method, etc. are considered as the method for forming the insulating film with good adaptability for filling the concave portions. However, since the above planarization methods do not employ the thermal fluidity step, it is difficult to bury the concave portions by the insulating film material completely if a distance between the interconnection layers is much more narrowed due to higher integration density.

In contrast, in the planarization method using fluidization by heating (reflow), complete filling adaptability can be expected since thermal fluidity is employed, as shown in FIGS.1A and 1B. At present, the BPSG film 4 is often used particularly in this application. However, since the BPSG film 4 has to be heated at least up to 850 °C to be reflowed, it is not applicable in the ground film 2 underlying the interconnection layers 3a, 3b and the interlayer insulating film 4, both films must be formed at the low temperature. Especially, the BPSG film 4 cannot be used as the insulating film for covering the aluminum interconnection layers. The reflow temperature can be reduced to some extent if phosphorus or boron concentration is enhanced. In this case, such reduction is insufficient and moreover another problem has arisen wherein stabilization and moisture resistance of the insulating glass films 2, 4 are degraded. For the PSG film, the reflow temperature is also required to the substantially same extent as the BPSG film and therefore the above problems occur similarly.

A GeBPSG film which can be formed by adding GeO₂ to the BPSG film has been developed as the insulating film with low reflow temperature, but the temperature can merely reduced up to about 750 °C at most. Therefore, it is hard to apply the GeBPSG film to the ground film and the interlayer insulating film which are to be processed at low temperature.

### SUMMARY OF THE INVENTION

It is an object of the present invention to provide an insulating film forming method capable of reducing extremely the reflow temperature for planarization and a semiconductor device manufacturing method.

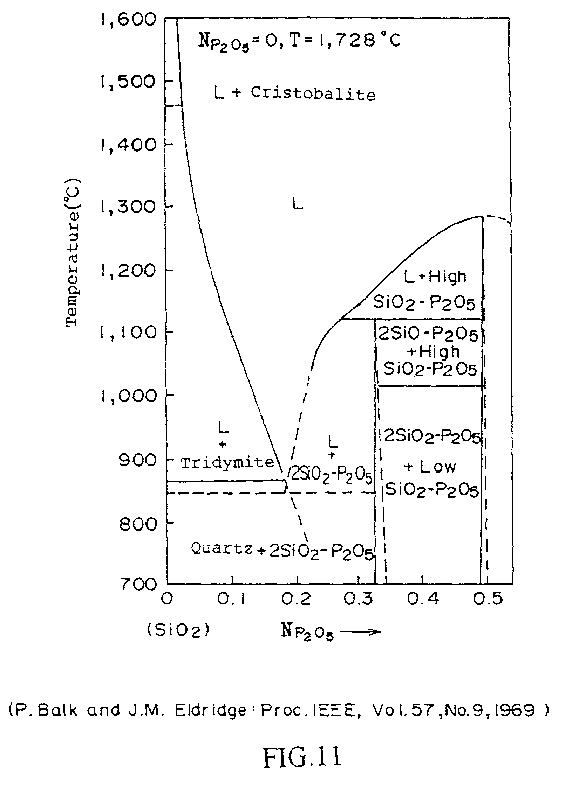

The inventors of the present invention have made much account of the following facts,
(1) the BPSG film or the PSG film in the prior art is formed of a mixture consisting of SiO₂+P₂O₅+B₂O₃ or a mixture consisting of SiO₂+P₂O₅ (Although PH₃ included in the reaction gas SiH₄+PH₃+B₂H₆+O₂ in the prior art is III valence phosphorus, it is bonded to externally supplied oxygen to thus generate P₂O₅ instead of P₂O₃. This is because, when PH₃ is bonded to externally supplied oxygen, stable P₂O₅ can be generated easily since PH₃ per se does not include oxygen.),
(2) the BPSG film of P₂O₅-SiO₂ system has an eutectic point of 850 °C theoretically over 20 to 80 % composition of P₂O₅, as shown in FIG.11, so that its reflow temperature is mainly determined according to the melting point of P₂O₅ itself, and
(3) P₂O₃ has an extremely lower melting point than P₂O₅, as shown in the following.

**TABLE I**

| | Melting point | Boiling point |
|---|---|---|
| P₂O₃(III valence) | 23.8 °C | 175.4 °C |
| P₂O₅(V valence) | 580-585 °C | 300 °C(sublimation) |
| (from Handbook of CRC chemistry published by CRC Press in 1978/88) | | |

Based on the above facts, the inventors of the present invention have considered that the reflow temperature can be lowered if the BPSG film or the PSG film is formed to include P₂O₃ mainly in place of P₂O₅.

For this reason, in order to accomplish the BPSG film or the PSG film having high P₂O₃ concentration, the inventors of the present invention have thought up a way to oxidize phosphorus containing compound in the oxygen deficient condition. As the concrete ways, (1) to use as the reaction gas the phosphorus containing compound in which P is included in the form of III valence, (2) to form the BPSG film or the PSG film using silicon containing compound or phosphorus containing compound including oxygen without additional oxygen or ozone, and others may be considered.

As the phosphorus containing compound including III valence P which can be applied to the way (1), there may be used, for example, the TMP (Trimethylphosphite (P(OCH₃)₃)) having the following formula 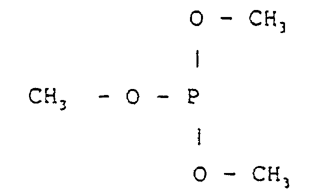 and the phosphorous acid dimethyl trimethylsilylester with the Si-O-P structure having the following formula 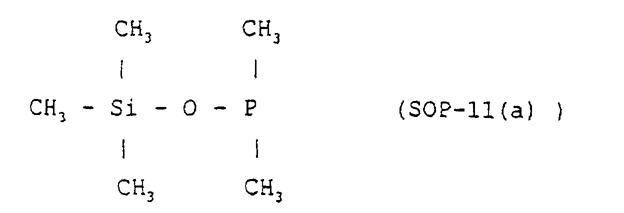 and the phosphorous acid dimethoxy trimethylsilylester with the Si-O-P structure having the following formula

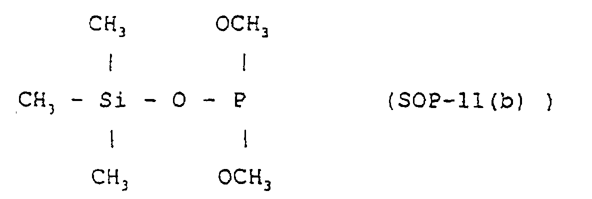

It should be understood that the TMP may also be applied to the way (2).

Therefore, after the PSG film has been formed in terms of the thermal CVD method or the plasma enhanced CVD method with the use of the reaction gas including the above phosphorus containing compound, components in the PSG film have been analyzed by the inventors by virtue of X-ray fluorescence (XRF) analysis or Fourier-transform infrared spectroscopy (FTIR). As a result, it has been confirmed by the inventors of the present invention that high concentration of P₂O₃ is included in the formed film. Further, the reflow temperature ranging over 240 to 430 °C can be achieved by the inventors of the present invention.

Still further, the inventors of the present invention have found the fact that it is feasible to control the reflow temperature by adjusting the P₂O₃ concentration and also such P₂O₃ concentration can be adjusted readily by adjusting film forming temperature, oxidizing gas (ozone) concentration, or gas flow rate of the phosphorus containing compound.

It should be understood that the above facts are similarly true for the BPSG film.

Other and further objects and features of the present invention will become obvious upon an understanding of the illustrative embodiments about to be described in connection with the accompanying drawings or will be indicated in the appended claims and various advantages not referred to herein will occur to one skilled in the art upon employing of the invention in practice.

### BRIEF DESCRIPTION OF THE DRAWINGS

FIGS.1A and 1B are sectional views showing an interlayer insulating film forming method including a planarization step in terms of heating and reflow in the prior art;
FIGS.2A to 2C are sectional views showing another interlayer insulating film forming method including the planarization step in terms of heating and reflow in the prior art;
FIGS.3A and 3B are sectional views showing still another interlayer insulating film forming method including the planarization step in terms of CMP in the prior art;

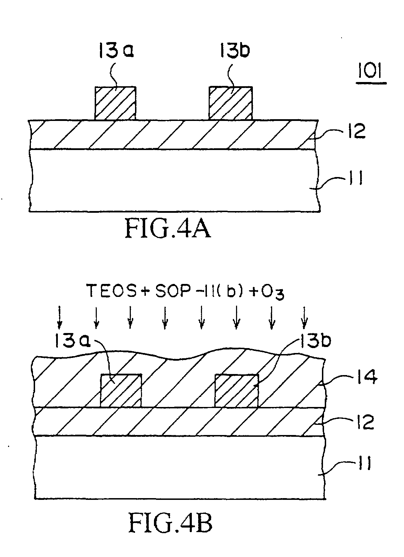

FIGS.4A and 4B are sectional views showing a film forming method for forming a PSG film including P₂O₃ according to a first embodiment of the present invention;

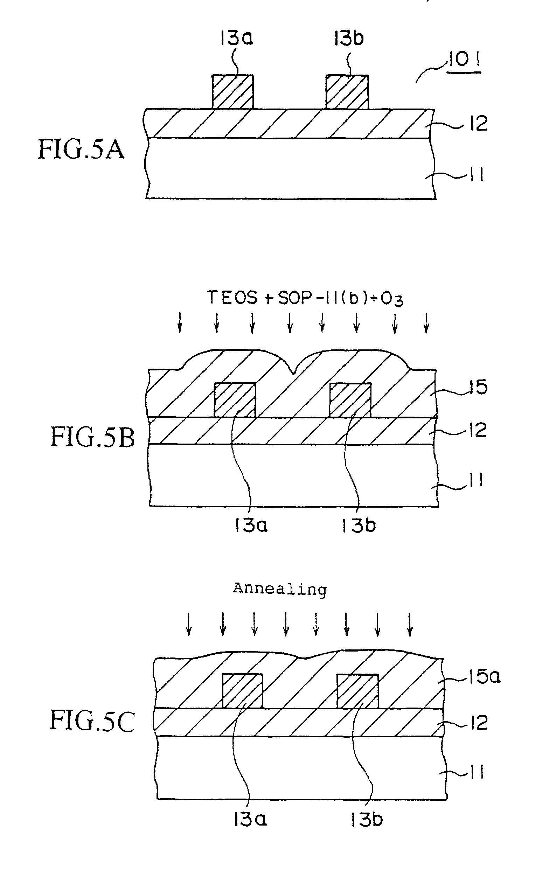

FIGS.5A to 5C are sectional views showing another film forming method for forming the PSG film including P₂O₃ according to the first embodiment of the present invention;

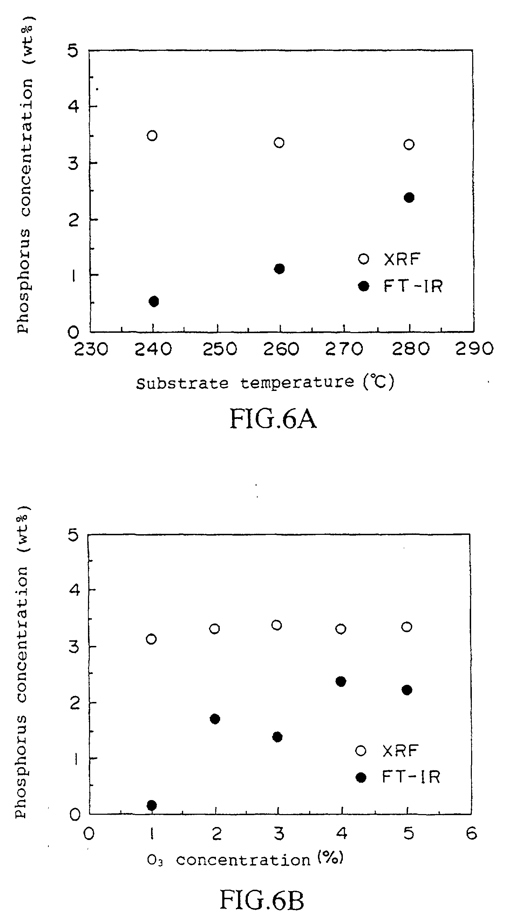

FIG.6A is a characteristic view showing relations between a substrate temperature and phosphorus concentration in the PSG film including P₂O₃ formed by the film forming method according to the first embodiment of the present invention;
FIG.6B is a characteristic view showing relations between ozone concentration and phosphorus concentration in the PSG film including P₂O₃ formed by the film forming method according to the first embodiment of the present invention;

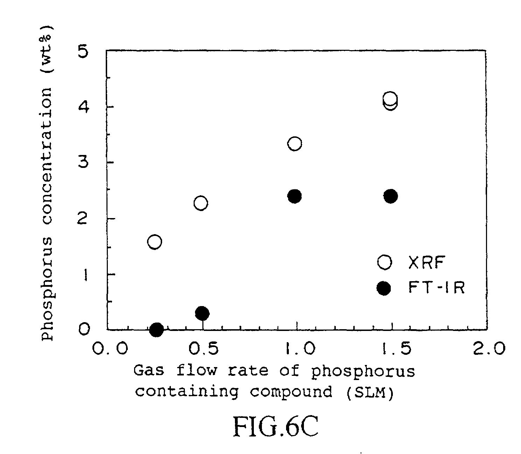

FIG.6C is a characteristic view showing relations between a gas flow rate of a phosphorus containing compound and phosphorus concentration in the PSG film including P₂O₃ formed by the film forming method according to the first embodiment of the present invention;

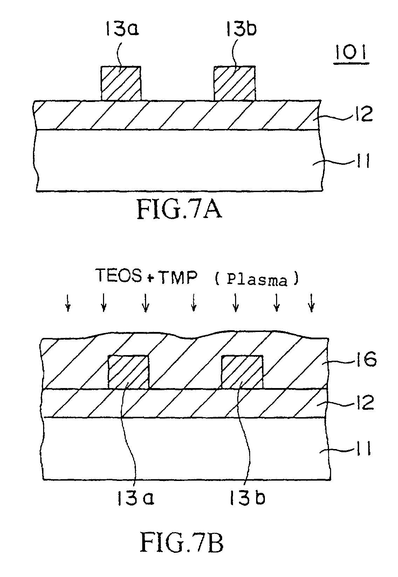

FIGS.7A and 7B are sectional views showing a film forming method for forming a PSG film including P₂O₃ according to a second embodiment of the present invention;

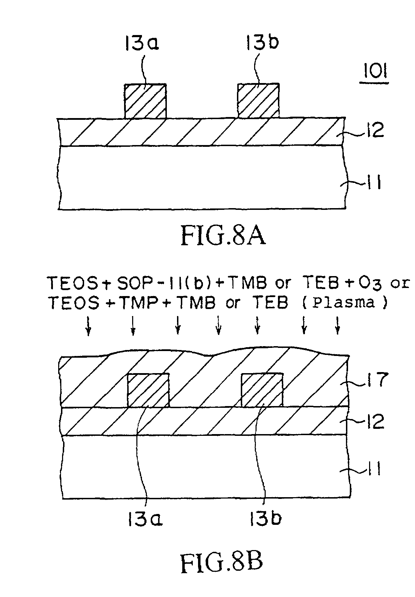

FIGS.8A and 8B are sectional views showing a film forming method for forming a BPSG film including P₂O₃ according to a third embodiment of the present invention;

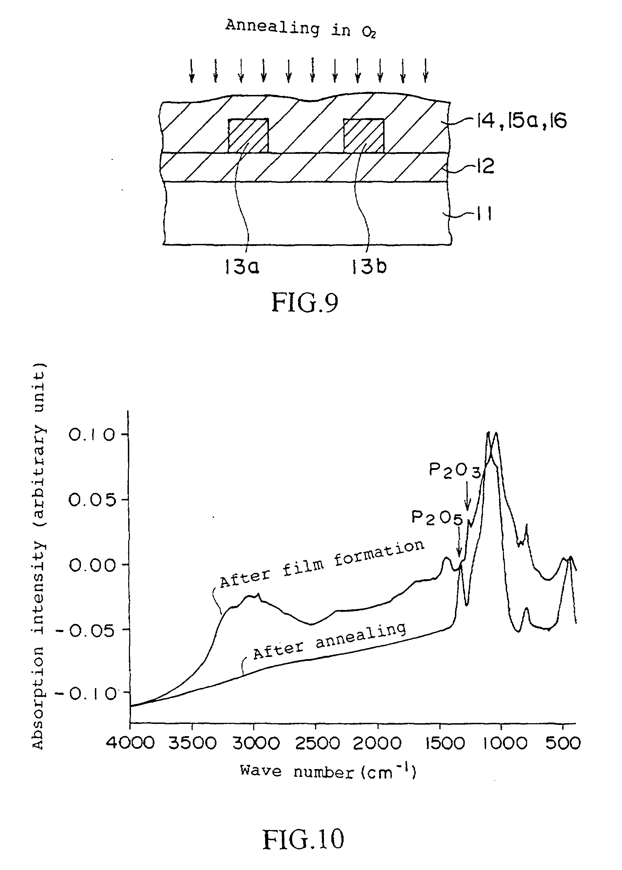

FIG.9 is a sectional view showing a method for stabilizing the PSG film including P₂O₃ according to a fourth embodiment of the present invention;
FIG.10 is a view showing the analysis results of types of phosphorus compound in the PSG film in terms of Fourier-transform infrared spectroscopy (FTIR) before and after stabilization according to the fourth embodiment of the present invention; and
FIG.11 is a phase diagram of P₂O₅-SiO₂ system glass.

### DETAILED DESCRIPTION OF THE EMBODIMENTS

Various embodiments of the present invention will be described with reference to the accompanying drawings. It should be noted that the same or similar reference numerals are applied to the same or similar parts and elements throughout the drawings, and the description of the same or similar parts and elements will be omitted or simplified.

### (1) First Embodiment

A method for forming a PSG film in terms of thermal CVD method will be explained according to a first embodiment of the present invention.

A gas mixture consisting of a phosphorus containing compound, a silicon containing compound, and an oxidizing gas is employed as a reaction gas.

As the phosphorus containing compound, TMP (trimethylphosphite (P(OCH₃)₃)) having a following formula 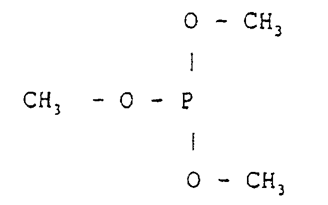 and a phosphorous acid dimethyl trimethylsilylester (referred to as "SOP-11(a)" hereinafter) with an Si-O-P structure having a following formula 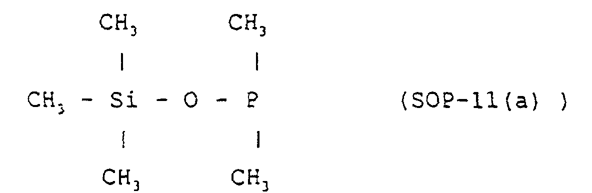 and a phosphorous acid dimethoxy trimethylsilylester (referred to as "SOP-11(b)" hereinafter) with an Si-O-P structure having a following formula 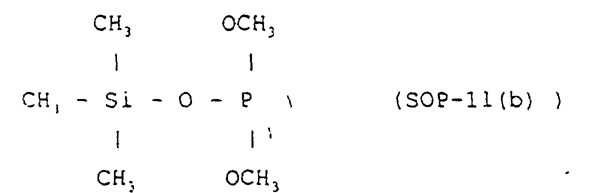 may be used selectively. In addition to the above, the phosphorus containing compound which has III valence phosphorus and has at least one bond of phosphorus to which oxygen is bonded may be used as the phosphorus containing compound. SOP-11(b) is used by way of illustration in this embodiment.

Then, as the silicon containing compound, alkylsilane or allylsilane (general formula: RₙSiH₄₋ₙ (n=1∼4)), alkoxysilane (general formula: (RO)ₙSiH₄₋ₙ (n=1∼4)), chain siloxane (general formula: RₙH₃₋ₙSiO(RₖH₂₋ₖSiO)ₘSiH₃₋ₙRₙ (n=1∼3; k=0∼2; m≧0)), derivative of chain siloxane (general formula: (RO)ₙH₃₋ₙSiOSiH₃₋ₙ(OR)ₙ (n=1∼3)), and ring siloxane (general formula: (RₖH₂₋ₖSiO)ₘ (k=1, 2; m≧ 2), etc. may be employed selectively. R is alkyl radial, allyl radical, or their derivative. By way of example, TMS (trimethoxysilane (CH₃O)₃SiH) of alkoxysilane is used in this embodiment.

In addition, as the oxidizing gas, ozone (O₃), oxygen (O₂), N₂O, NO₂, CO, CO₂, H₂O, etc. may be employed selectively. For the purposes of illustration, ozone is used in this embodiment.

The gas mixture consisting of the silicon containing compound, i.e., tetraethylorthosilicate (TEOS), the phosphorus containing compound (SOP-11(b)), and the oxidizing gas (ozone (O₃)) is used as the reaction gas. In order to collect comparative data, film forming conditions of various film forming parameters are changed as shown in the following.

**TABLE II**

| Film forming parameter | Film forming condition |
|---|---|
| Substrate temperature | 240, 260, 280 °C |
| Ozone concentration | 1, 2, 3, 4, 5 % |
| Gas flow rate of SOP-11(b) | 0.25, 0.5, 1.0, 1.5 SLM |

In this case, as for film forming parameters other than the above film forming parameters whose film forming conditions are changed, film forming conditions are set to standard values of respective film forming conditions. Such standard values of the film forming conditions of the film forming parameters are given in the following.

**TABLE III**

| Film forming parameter | Standard film forming condition |
|---|---|
| Substrate temperature | 240 °C |
| Ozone concentration | 1 % |
| Gas flow rate of SOP-11(b) | 0.25 SLM |

In this event, since SOP-11(b) is a liquid at normal temperature, it is contained in a carrier gas (N₂) in terms of bubbling of the carrier gas (N₂). A SOP-11(b) content can be controlled by adjusting a flow rate of the carrier gas. A part of oxygen can be converted into ozone by the ozonizer. An ozone concentration denotes an amount of ozone contained in oxygen.

First, a deposition substrate 101 shown in FIG.4A is loaded into a chamber of a thermal CVD equipment. Then, the deposition substrate 101 is heated and then maintained at a predetermined substrate temperature. The deposition substrate 101 is so formed that a ground insulating film 12 such as a silicon oxide film, for example, is formed on a silicon substrate (semiconductor substrate) 11 and then interconnection layers 13a, 13b such as an aluminum film, for example, are formed on the ground insulating film 12.

Next, as shown in FIG.4B, the reaction gas is introduced into the chamber. The deposition substrate 101 is kept in this state for a predetermined time. As a result, a PSG film 14 including high concentration P₂O₃ is formed to have a predetermined thickness. In some cases, reflowing of the PSG film 14 is caused around a substrate temperature according to P₂O₃ concentration or a ratio of P₂O₃/P₂O₅ during forming film. In this event, planarization as well as film formation can be achieved. Unless planarization can be achieved, as shown in FIGS.5A to 5C, after a PSG film 15 is formed on the deposition substrate 101, the PSG film 15a is reflowed by annealing separately so that a surface of the PSG film 15a is planarized.

Phosphorous (P) concentration in the PSG film 14 which is formed by the above steps is detected in terms of X-ray,fluorescence analysis (XRF) and Fourier-transform infrared spectroscopy (FTIR). Total concentration of P₂O₃+P₂O₅ in the PSG film 14 can be detected in terms of X-ray fluorescence analysis (XRF) and only P₂O₅ concentration in the PSG film 14 can be detected in terms of Fourier-transform infrared spectroscopy (FTIR).

Analysis results are shown in FIGS.6A to 6C. FIG.6A shows dependence of the phosphorous content in the PSG film on the substrate temperature, wherein an ordinate indicates the phosphorus concentration (wt%) in linear scale while an abscissa indicates the substrate temperature (°C) in linear scale. FIG.6B shows dependence thereof on the ozone concentration, wherein an ordinate indicates the phosphorus concentration (wt%) in linear scale while an abscissa indicates the ozone concentration (%) in linear scale. FIG.6C shows dependence thereof on the gas flow rate of a phosphorus containing compound, wherein an ordinate indicates the phosphorus concentration (wt%) in linear scale while an abscissa indicates the gas flow rate of SOP-11 (SLM) in linear scale.

In FIGS.6A to 6C, white round marks represent total concentration of P₂O₃+P₂O₅ in the PSG film, which are the analysis results in terms of XRF. Black round marks represent P₂O₅ concentration in the PSG film, which are the analysis results in terms of FTIR. In FIGS.6A to 6C, differences between white round marks and black round marks correspond to P₂O₃ concentration in the PSG film.

From the above results, it has been found that P₂O₃ concentration or a rate of P₂O₃/P₂O₅ in the PSG film thus formed can be adjusted by controlling the substrate temperature, the ozone concentration, and the gas flow rate of SOP-11.

Furthermore, a melting temperature or reflow temperature of the PSG film 14 becomes lower as the P₂O₃ concentration or the rate of P₂O₃/P₂O₅ in the PSG film 14 becomes higher. The melting temperature or reflow temperature of 500 °C or lower has been derived from the experiments.

### (2) Second Embodiment

A method for forming a PSG film including P₂O₃ in terms of plasma enhanced CVD method will be explained with reference to FIGS.7A and 7B according to a second embodiment of the present invention.

As the reaction gas, a gas mixture of TEOS+TMP is employed. In order to satisfy an oxygen deficient condition sufficiently, no oxygen (O₂) is added to the reaction gas. The constitutional formula of TMP (trimethylphosphite (P(OCH₃)₃)) is shown in the following.

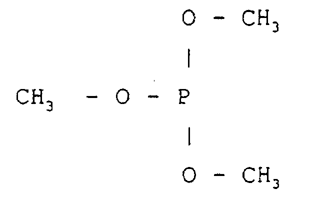

Film forming conditions are given as follows. Plasma enhanced CVD method based on ECR method is employed as the film forming method.

**TABLE IV**

| Film forming parameter | Film forming condition |
|---|---|
| Substrate temperature | 240 - 400 °C |
| Gas pressure in chamber | 3 mTorr (1 Torr = 133.3 Pa) |
| TEOS flow rate | 0.1 - 1 SLM |
| TMP flow rate | 0.1 - 0.5 SLM |
| Applied power | 50 W - 2.3 kW |
| Frequency | 2.45 GHz |
| Substrate bias power | 50 - 300 W |
| Frequency | 13.56 MHz |

In forming the film, a PSG film 16 which is provided with flow capability can flow into a recess between the interconnection layers 13a, 13b at a substrate temperature of about 200 °C. FIG.7A shows a sectional shape of the deposition substrate 101 before the PSG film 16 is formed thereon. FIG.7B shows a sectional shape of the PSG film 16 formed on the deposition substrate 101 after the film formation has been completed.

From the foregoing experimental results, it can be deduced that phosphorus is included in the PSG film 16 in the form of III valence P₂O₃. Since oxygen is not supplied from the external, the reaction system is under the oxygen deficient condition and therefore it may be supposed that Si-O and P-O in the PSG film 16 are bonded to oxygen atoms in molecules respectively.

In the second embodiment, no oxygen has been added. However, needless to say, like the first embodiment, the melting temperature or reflow temperature of the PSG film 16 can also be controlled by adjusting the P₂O₃ concentration or the ratio of P₂O₃/P₂O₅ in the PSG film 16. Still further, like the first embodiment, the melting temperature or reflow temperature of the PSG film 16 can also be controlled via the adjustment of the P₂O₃ concentration or the ratio of P₂O₃/P₂O₅ even if other film forming parameters such as the substrate temperature or TMP flow rate is controlled.

### (3) Third Embodiment

A method for forming a BPSG film including P₂O₃ in terms of thermal CVD method or plasma enhanced CVD method will be explained with reference to FIGS.8A and 8B according to a third embodiment of the present invention.

A gas mixture of TEOS+SOP-11(b)+TMP or TEB+O₂ or O₃ is employed as the reaction gas.

Film forming conditions are given in the following.

**TABLE V**

| <Thermal CVD method> | |
|---|---|
| Film forming parameter | Film forming condition |
| Substrate temperature | 200 - 400 °C |
| Ozone concentration | 0.3 - 2.5 % |
| Gas flow rate of SOP-11(b) | 0.1 - 1.5 SLM |
| Gas flow rate of TMB or TEB | 0.1 - 1.0 SLM |

**TABLE VI**

| <Plasma enhanced CVD method (ECR P-CVD method)> | |
|---|---|
| Film forming parameter | Film forming condition |
| Substrate temperature | 80 - 350 °C |
| Gas pressure in chamber | 3 - 100 mTorr |
| TEOS flow rate | 0.05 - 0.3 SLM |
| TMP flow rate | 0.05 - 0.5 SLM |
| TMB or TEB flow rate | 0.05 - 0.4 SLM |
| Applied power | 200 W - 1.5 kW |
| Frequency | 13.56 MHz |
| Substrate bias power | 100 - 300 W |
| Frequency | 13.56 MHz |

FIG.8A shows a sectional shape of the deposition substrate 101 before a BPSG film 17 is formed thereon. Under the above condition, as shown in FIG. 8B, the BPSG film 17 consisting of a mixture of SiO₂+P₂O₃+B₂O₃ is formed on the deposition substrate 101.

In the same manner as in the first embodiment, the P₂O₃ concentration or the rate of P₂O₃/P₂O₅ can be adjusted by controlling oxygen concentration or ozone concentration, substrate temperature, the phosphorus containing compound or the boron containing compound, so that a melting point of the BPSG film 17 has been able to be controlled in the range of 200 °C to 500 °C.

### (4) Fourth Embodiment

In the meanwhile, because P₂O₃ per se readily reacts to humidity, the PSG films 14, 15a, 16 and the BPSG film 17 being formed as described above would absorb humidity when they are unloaded from the chamber in the air after film formation has been completed. Therefore, in order to use them as the interlayer insulating glass film, etc. of the semiconductor device, the PSG films 14, 15a, 16 and the BPSG film 17 including P₂O₃ must be stabilized to prevent such humidity absorption.

Subsequently, a method for stabilizing the PSG films 14, 15a, 16 including P₂O₃ will be explained with reference to FIG.9 according to a fourth embodiment of the present invention.

After the PSG film 14, 15a, 16 has been formed by the film forming method according to the first embodiment, N₂+O₂ is introduced into the chamber, i.e., a sealed container and then the PSG film 14, 15a, 16 is annealed at a temperature of about 500 °C in such atmosphere.

FIG.10 shows the FTIR analysis results of types of phosphorus compound in the PSG films 14, 15a, 16 before and after annealing, i.e., stabilization according to the fourth embodiment of the present invention. As shown in FIG.10, P₂O₃ in the PSG films 14, 15a, 16 can be changed into P₂O₅ by annealing.

As stated earlier, the PSG films 14, 15a, 16, etc. can be stabilized by changing P₂O₃ into P₂O₅ in terms of annealing in oxygen atmosphere after film formation. Further, final composition of P₂O₅ can provide a passivation effect to the PSG films 14, 15a, 16, etc. to thus contribute to stabilization of boundary characteristics. Remaining carbon included in the PSG film can be oxidized simultaneously by such annealing.

With the above process, the PSG films 14, 15a, 16, etc. may be applied to the device.

In place of such annealing or together with such annealing, a cover insulating film may be formed on the PSG films 14, 15a, 16, etc. to prevent humidity absorption.

The thermal CVD equipment or the plasma enhanced CVD equipment is employed as the CVD equipment and then an annealing furnace is employed to improve film quality. To enable improvement of the film quality directly without exposure of the PSG film to the atmosphere after film formation, it is desirable to employ such an equipment that the CVD equipment and the annealing furnace are connected by a load lock chamber as a whole film forming equipment.

In the above first to fourth embodiments, since the insulating film having high P₂O₃ concentration as phosphorous component is formed, the reflow temperature can be extremely lowered to 500 °C or lower. Hence, the PSG film and the BPSG film can be used as the interlayer insulating film to cover the aluminum interconnection. Even if, in the semiconductor device in which shallower diffusion layers are formed with the progress of high integration density, the PSG film and the BPSG film are used as the ground insulating film for the interconnection layer, redistribution of impurity in the diffusion layer can be prevented.

In addition, since the interlayer insulating film can be planarized by means of thermal fluidization without planarization method such as CMP method after film formation, concave portions between the interconnection layers, etc. can be buried to leave no space, i.e., not to produce the voids, in the interlayer insulating film.

## Claims

1. A film forming method comprising the steps of:
a) supplying a reaction gas including a silicon containing compound and a phosporus containing compound which has III valence phosphorus and has at least one bond of phosphorus to which oxygen is bonded;
b) forming a phosphorus containing glass film (14, 15, 16 or 17) wherein the phosphorus containing component is mainly P₂O₃ on a deposition substrat (101);
c) heating and reflowing said glass film (14, 15, 16 or 17) such that the surface thereof is planarized; and
d) heating said glass film (14, 15, 16 or 17) including P₂O₃ in oxygen containing atmosphere so as to convert the P₂O₃ in said insulating glass film (14, 15, 16 or 17) into P₂O₅.

2. The film forming method of claim 1, wherein said phosphorus containing compound which has III valence phosphorus and has at least one bond of phosphorus to which oxygen is bonded, is formed of any one of (i) TMP (Trimethylphosphite (P(OCH₃)₃)) having the following formula 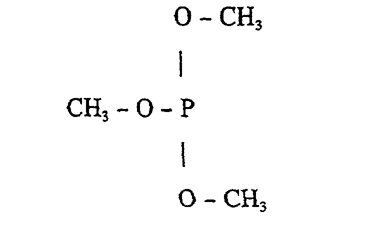 (ii) a phosphorus acid dimethyl trimethylsilylester with an Si-O-P structure having the following formula 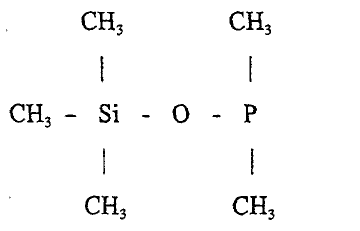 and (iii) a phosphorous acid dimethoxy trimethylsilylester with an Si-O-P structure having the following formula

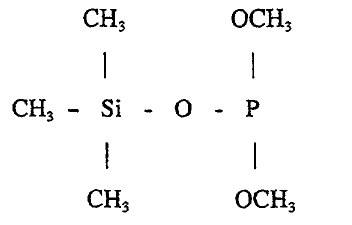

3. The film forming method of claim 1, wherein said reaction gas is excited by heating or plasmarization.

4. The film forming method of claim 1, wherein said deposition substrate (101) is heated at 400°C or lower during said forming step.

5. The film forming method of claim 1, wherein said glass film (14, 15, 16 or 17) including P₂O₃ is formed of a phosphosilicate glass film (PSG film) or a borophosphosilicate glass film (BPSG film).

6. The film forming method of claim 1, wherein said glass film (15) is heated in step (c) at a temperature of 700°C or lower.

7. The film forming method of claim 1, wherein said glass film (15) is heated in step (c) at a temperature of 500°C of lower.

8. A semiconductor device manufacturing method comprising the steps of:
forming an interconnection layer (13a, 13b) on an insulating film (12); and
forming a phosphorus containing glass film by the film forming method according to any one of claims 1 to 7 to cover said interconnection layer on said insulating film.

9. A semiconductor device manufacturing method of claim 8, wherein material of said interconnection layer is formed of aluminium or aluminium alloy.

## Patentansprüche

1. Filmbildungsverfahren, umfassend die Schritte:
a) Bereitstellen eines Reaktionsgases, umfassend eine Silizium-enthaltende Verbindung und eine Phosphor-enthaltende Verbindung, die dreiwertigen Phosphor aufweist und mindestens eine Bindung des Phosphors hat, an die Sauerstoff gebunden ist;
b) Bilden eines Phosphor-enthaltenden Glasfilms (14, 15, 16 oder 17), worin die Phosphor-enthaltende Komponente hauptsächlich P₂O₃ darstellt, auf einem Abscheidungssubstrat (101);
c) Erwärmen und Aufschmelzen (Reflow) des Glasfilms (14, 15, 16 oder 17), so dass die Oberfläche desselben eingeebnet wird; und
d) Erwärmen des Glasfilms (14, 15, 16 oder 17), umfassend P₂O₃, in einer Sauerstoffenthaltenden Atmosphäre, um das P₂O₃ in dem isolierenden Glasfilm (14, 15, 16 oder 17) in P₂O₅ umzuwandeln.

2. Filmbildungsverfahren gemäß Anspruch 1, worin die Phosphor-enthaltende Verbindung, die dreiwertigen Phosphor aufweist und mindestens eine Bindung des Phosphors hat, an die Sauerstoff gebunden ist, gebildet wird aus jedem von (i) TMP (Trimethylphosphit (POCH₃)₃)) mit der folgenden Formel 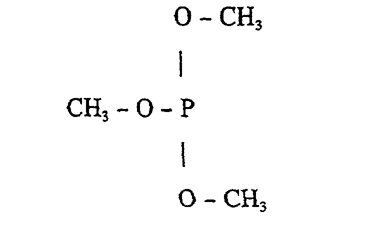 (ii) einem Phosphorsäure-dimethyl-trimethylsilylester mit einer Si-O-P-Struktur mit der folgenden Formel 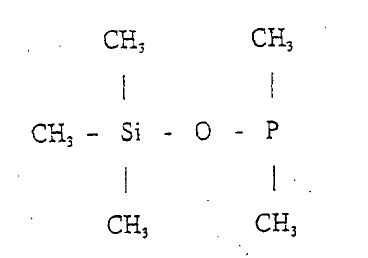 und (iii) einem Phosphorsäure-dimethoxy-trimethylsilylester mit einer Si-O-P-Struktur mit der folgenden Formel

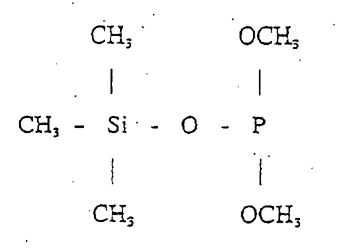

3. Filmbildungsverfahren gemäß Anspruch 1, worin das Reaktionsgas durch Erwärmen oder Plasmarisierung angeregt wird.

4. Filmbildungsverfahren gemäß Anspruch 1, worin das Abscheidungssubstrat (101) während des Bildungsschrittes auf 400 °C oder darunter erwärmt wird.

5. Filmbildungsverfahren gemäß Anspruch 1, worin der Glasfilm (14, 5, 16 oder 17), umfassend P₂O₃, aus einem Phosphorsilikatglasfilm (PSG-Film) oder einem Borphosphorsilikatglasfilm (BPSG-Film) gebildet ist.

6. Filmbildungsverfahren gemäß Anspruch 1, worin der Glasfilm (15) in Schritt (c) auf eine Temperatur von 700 °C oder darunter erwärmt wird.

7. Filmbildungsverfahren gemäß Anspruch 1, worin der Glasfilm (15) in Schritt (c) auf eine Temperatur von 500 °C oder darunter erwärmt wird.

8. Verfahren zur Herstellung eines Halbleiterbauteils, umfassend die Schritte:
Ausbilden einer Verbindungsschicht (13a, 13b) auf einem isolierenden Film (12); und
Ausbilden eines Phosphor-enthaltenden Glasfilms über das Filmbildungsverfahren gemäß einem der Ansprüche 1 bis 7, um die Verbindungsschicht auf dem isolierenden Film zu bedecken.

9. Herstellungsverfahren für ein Halbleiterbauteil gemäß Anspruch 8, worin das Material der Verbindungsschicht aus Aluminium oder einer Aluminiumlegierung gebildet ist.

## Revendications

1. Procédé de formation d'un film comprenant les étapes consistant :
a) à fournir un gaz de réaction incluant un composé contenant du silicium et un composé contenant du phosphore qui a du phosphore de valence III et a au moins une liaison du phosphore à laquelle de l'oxygène est lié ;
b) à former un film de verre contenant du phosphore (14, 15, 16 ou 17) dans lequel le constituant contenant du phosphore est principalement P₂O₃ sur un substrat de déposition (101) ;
c) à chauffer et à faire couler de nouveau ledit film de verre (14, 15, 16 ou 17) de sorte que la surface de celui-ci soit aplanie ; et
d) à chauffer ledit film de verre (14, 15, 16 ou 17) incluant P₂O₃ dans une atmosphère contenant de l'oxygène de façon à convertir le P₂O₃ dans ledit film de verre isolant (14, 15, 16 ou 17) en P₂O₅.

2. Procédé de formation de film selon la revendication 1, dans lequel ledit composé contenant du phosphore qui a du phosphore de valence III et a au moins une liaison du phosphore à laquelle de l'oxygène est lié est formé de l'un quelconque parmi (i) le TMP (Triméthylphosphite (P(OCH₃)₃)) ayant la formule suivante 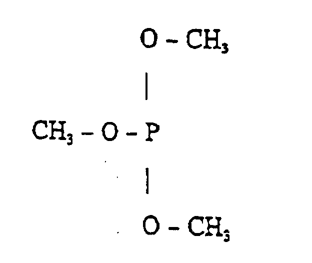 (ii) un diméthyl triméthylsilylester d'acide phosphoreux ayant une structure Si-O-P ayant la formule suivante 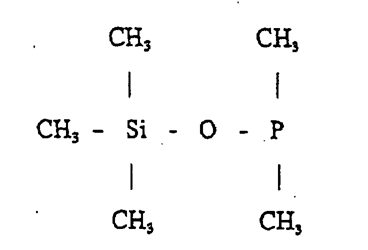 et (iii) un diméthoxy triméthylsilylester d'acide phosphoreux ayant une structure Si-O-P ayant la formule suivante

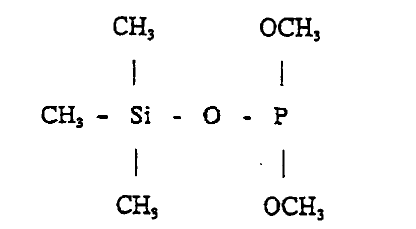

3. Procédé de formation d'un film selon la revendication 1, dans lequel ledit gaz de réaction est excité par chauffage ou par plasma.

4. Procédé de formation d'un film selon la revendication 1, dans lequel ledit substrat de déposition (101) est chauffé à une température de 400 °C ou inférieure pendant ladite étape de formation.

5. Procédé de formation d'un film selon la revendication 1, dans lequel ledit film de verre (14, 15, 16 ou 17) incluant P₂O₃ est formé d'un film de verre de phosphosilicate (film PSG) ou d'un film de verre de borophosphosilicate (film BPSG).

6. Procédé de formation d'un film selon la revendication 1, dans lequel ledit film de verre (15) est chauffé dans l'étape (c) à une température de 700 °C ou inférieure.

7. Procédé de formation de film selon la revendication 1, dans lequel ledit film de verre (15) est chauffé dans l'étape (c) à une température de 500 °C ou inférieure.

8. Procédé de fabrication d'un dispositif semiconducteur, comprenant les étapes consistant :
à former une couche d'interconnexion (13a, 13b) sur un film isolant (12) ; et
à former un film de verre contenant du phosphore par le procédé de formation d'un film selon l'une quelconque des revendications 1 à 7 pour recouvrir ladite couche d'interconnexion sur ledit film isolant.

9. Procédé de fabrication d'un dispositif semiconducteur selon la revendication 8, dans lequel le matériau de ladite couche d'interconnexion est formé d'aluminium ou d'un alliage d'aluminium.
